(19) Europäisches Patentamt
European Patent Office
Office européen des brevets

(11) Publication number: **0 128 320**
**A1**

(12) **EUROPEAN PATENT APPLICATION**

(21) Application number: **84104840.8**

(22) Date of filing: **30.04.84**

(51) Int. Cl.³: **C 08 F 2/50**, G 03 C 1/68

(30) Priority: **08.06.83 US 502412**

(43) Date of publication of application: **19.12.84**
**Bulletin 84/51**

(84) Designated Contracting States: **AT BE CH DE FR GB IT LI NL SE**

(71) Applicant: **STAUFFER CHEMICAL COMPANY, Westport Connecticut 06880 (US)**

(72) Inventor: **Via, Francis Anthony, 2389 Ridge Street, Yorktown Heights New York 10598 (US)**

(74) Representative: **Jaeger, Klaus, Dr. et al, JAEGER & PARTNER Patentanwälte Bergstrasse 48 1/2, D-8035 München-Gauting (DE)**

(54) **Amine promotion of benzoin ether photoinitiators.**

(57) The use of amine compounds, e.g., tertiary amines containing alkanol groups, enhances the photoinitiation of benzoin ether photoinitiators.

EP 0 128 320 A1

# AMINE PROMOTION OF BENZOIN ETHER PHOTOINITIATORS

## Background of the Present Invention

### Field of the Invention

The present invention relates to the promotion of the photoinitiation reaction of benzoin ether photoinitiators.

### Description of the Prior Art

The terminology "benzoin ether" as used herein is intended to cover those compounds that have photoinitiator action which contain at least one -OR group on the alpha carbon atom adjacent the carbonyl group bridging the two phenyl rings contained in the compound. Such compounds are of the formula

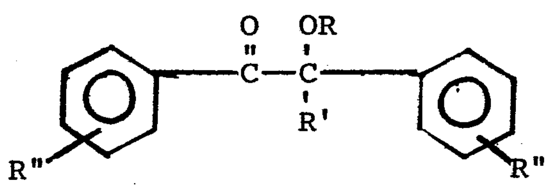

where R is alkyl, R' is either hydrogen, alkyl, halogen or alkoxy, and where R" is independently alkyl, alkoxy, halogen and alkylamino. More than one R" group can be present on either of the phenyl rings to substitute for the hydrogen atom normally present. When R' is alkoxy, these compounds can also be called the ketals of benzil.

Commercial photoinitiators of this type are sold under the trademarks VICURE-10 (R = isobutyl and

R' = hydrogen) and VICURE-30 (R = isopropyl and R' = hydrogen) by Stauffer Chemical Company and IRGACURE 651 (R = methyl and R' = methoxy) by Ciba-Geigy Corporation.

## Summary of the Present Invention

It has now been found that the action of the above type of benzoin ether photoinitiator can be enhanced or promoted by the use of an effective amount of an amine promoter, e.g., a tertiary amine containing alkanolamine groups.

## Detailed Description of the Present Invention

The compositions curable by actinic radiation according to the invention can contain a polymerizable polymer in a reactive ethylenically unsaturated monomeric medium, a reactive polymer alone, a reactive monomer alone, or any of these combined with an inert solvent. Additionally, the polymerizable composition can contain any of the pigments commonly used in photopolymerization techniques.

The process can be carried out by mixing a quantity of photoinitiating compound of the present invention with a photopolymerizable composition and exposing the resultant mixture to actinic radiation. Alternatively, a one-component system comprising the photopolymerizable composition, the photoinitiator of the invention and, if desired, pigmentation, can be formed.

The photoinitiating compounds of the invention are suitable in the actinic light curing of unsaturated

monomeric compounds either alone or as copolymerizable constituents of unsaturated polymer/monomer systems. Such systems are composed of mixtures of conventional unsaturated polymers and unsaturated monomers.

Monomers which are useful in practicing the invention are acrylic, α-alkacrylic and α-chloroacrylic acid compounds such as esters, amides and nitriles. Examples of such compounds are acrylonitrile, methacrylonitrle, methyl acrylate, ethyl acrylate, methyl methacrylate, isobutyl methacrylate, 2-ethylhexyl acrylate, methacrylamide and methyl α-chloroacrylate. Also useful, although not preferred due to their slower rates of reactivity, are vinyl and vinylidene esters, ethers and ketones. Additionally, compounds having more than one terminal unsaturation can be used. Examples of these include diallyl phthalate, diallyl maleate, diallyl fumarate, triallyl cyanurate, triallyl phosphate, ethylene glycol dimethylacrylate, glycerol trimethylacrylate, pentaerythritol triacrylate, pentaerythritol tetraacrylate, trimethylolpropane triacrylate, methacrylic anhydride, and allyl ethers of monohydroxy or polyhydroxy compounds, such as ethylene glycol diallyl ether, pentaerythritol, tetraallyl ether, and the like. Nonterminally unsaturated compounds such as diethyl fumarate can similarly be used.

The acrylic acid derivatives are particularly well suited to the practice of the invention and are consequently preferred components as monomers in monomer-containing polymerizable systems and as reactive centers in polymerizable polymers. While monomeric styrene can be used in the practice of the invention, it is not a preferred constituent of systems polymerizable thereby due to its slow rate of reaction.

A preferred manner of practicing the invention is by the use of photopolymerizable molding and coating compositions which comprise mixtures of unsaturated polymeric compounds and monomeric compounds copolymerizable therewith. The polymeric compounds can be conventional polyesters prepared from unsaturated polycarboxylic acids such as maleic acid, fumaric acid, glutaconic acid, itaconic acid, citraconic acid, mesaconic acid and the like, and polyhydric alcohols such as ethylene glycol, diethylene glycol, glycerol, propylene glycol, 1,2-butanediol, 1,4-butanediol, pentaerythritol, trimethylolpropane and the like. The carboxylic acid content can also conatin saturated components. The inclusion of a monobasic fatty acid content, either as such or in the form of a triglyceride or oil, in the photopolymerizable polyester composition to comprise an alkyd resin is also acceptable. These resins can, in turn, be modified by silicones, epoxides, isocyanates, etc., by known techniques.

The photoinitiator combination of the present invention comprises the benzoin ether photoinitiator compounds described above in conjunction with an amine promoter which is present in an effective amount to achieve the desired promotion effect, e.g., from about 0.1% to about 10%, by weight of the photopolymerizable composition. Such amines can be primary, secondary, or preferably tertiary and have been described as promoters for glyoxylamide photoinitiators. They have the formula

$$R'R''R'''N$$

with R' and R'' independently selected from hydrogen,

straight chain or branched alkyl having from 1 to about 12 carbon atoms, straight chain or branched alkenyl having from 2 to about 12 carbon atoms, cycloalkyl having from 3 to about 10 ring carbon atoms, cycloalkenyl having from 3 to about 10 ring carbon atoms, aryl having from 6 to about 12 ring carbon atoms, alkaryl having 6 to about 12 ring carbon atoms; R''' has the same meaning as R' and R'' with the exception that it cannot be hydrogen and that it cannot be aryl when both R' and R'' are aryl. Also, when taken together R'' and R''' can be a divalent alkylene group having from 2 to about 12 carbon atoms, a divalent alkylene group having from 3 to about 10 carbon atoms, a divalent alkadienylene group having from 5 to 10 carbon atoms, a divalent alkatrienylene group having from 5 to about 10 carbon atoms, a divalent alkyleneoxyalkylene group having a total of from 4 to about 12 carbon atoms, or a divalent alkyleneaminoalkylene group having a total of from 4 to about 12 carbon atoms. As previously indicated, the amines can be substituted with other groups; thus, the R', R'' and R''' variables whether taken singly or together can contain one or more substituents thereon. The nature of such substituents is generally not of significant importance and any substituent group can be present that does not exert a pronounced deterrent effect on the photoinitiation and polymerization.

Exemplary suitable organic amines are methylamine, dimethylamine, triethylamine, isopropylamine, triisopropylamine, tributylamine, t-butylamine, 2-methylbutylamine, N-methyl-N-butylamine, di-2-methylbutylamine, tri-2-ethylhexylamine, dodecylamine, tri-2-chloroethylamine, di-2-bromoethylamine, methanolamine, triethanolamine, dimethylethanolamine, methyldiethanolamine,

propanolamine, triisopropanolamine, butylethanolamine, dihexanolamine, 2-methoxyethylamine, 2-hydroxyethyl-diisopropylamine, allylamine, cyclohexylamine, trimethylcyclohexylamine, bis-methylcyclopentylamine, tricyclohexadienylamine, N-methyl-N-cyclohexylamine, N-2-ethylhexyl-N-cyclohexylamine, tribenzylamine, benzyldimethylamine, piperidine, N-ethylpiperidine, morpholine, N-methyl morpholine, N-2-hydroxyethyl-morpholine, piperazine, N,N'-dimethylpiperazine, and the like. The preferred organic amines are the tertiary amines, with the alkanol amines being most preferred.

Additionally, the photopolymerizable composition can contain a sensitizer capable of enhancing the photoinitiating efficiency of the photoinitiating compound of the invention. Examples of sensitizers useful in the practice of the invention are such compounds as xanthone, thioxanthone, acetophenone and benzophenone. These are typically added in amounts ranging from about 0.1 to about 6 weight percent. The techniques whereby such sensitizers are selected for use in conjunction with particular photoinitiators are well known in the art. See for example, Murov, Handbook of Photochemistry, Marcel Dekker, Inc., New York (1973).

Thus it is seen that the constitution of photopolymerizable compositions which can be used in the practice of the invention is widely variable. However, the compounds enumerated above are purely illustrative. Materials subject to polymerization by actinic radiation as well as permissible variations and substitutions of

equivalent components within particular types of compositions are well known to those skilled in the art.

The benzoin ether photoinitiators of the invention can be utilized in amounts ranging from 0.01 to about 30% by weight based on the photopolymerizable composition. However, preferable amounts of the compounds are from about 0.5 to about 20 weight percent with optimal results being achieved with amounts in the range of from about 1.0 to about 16 weight percent.

An acceptable source of actinic light radiation is any apparatus which emits light radiation in the approximate region of from about 2000 Angstroms to about 8000 Angstroms and preferably from about 2400 Angstroms to about 5400 Angstroms. One such apparatus is PPG Model QC 1202, a UV processor, manufactured by PPG Industries, Inc.

The present invention is illustrated by the Examples which follow.

TEST PROCEDURE USED IN THE EXAMPLES

The induced rate of photopolymerization of a standard test solution of acrylate/alkyd resin was measured for each of the compounds tested. This standard test solution consisted of 42%, by weight, trimethylolpropane triacrylate (TMPTA), 17% by weight, of ethylhexyl acrylate (EHA), and 41%, by weight of an unsaturated long chain linseed oil alkyd resin (ACTOMER X-80 Resin from Union Carbide).

The test solution was exposed to light radiation from a light source (PPG Model QC 1202) which contained two high intensity, medium pressure quartz mercury lamps, 12 inches in length, with each operating at a linear power density of about 200 watts per inch or 2400 watts per lamp. The lamps were housed in an elliptical reflector above a variable speed conveyor belt so that each lamp provided a 2-inch band of high flux actinic radiation on the conveyor. This 2-inch exposure area was bordered on both sides by an additional 2-inch area of medium flux energy for a total radiation area of 6 inches for each lamp. In the curing data presented herein, the cure rate of the polymerizable compositions is presented in feet-per-minute-per-lamp (ft./min./lamp). Thus, a conveyor belt speed of one foot/min. will, with a 12-inch exposure area for the two lamps, provide 60 seconds of exposure or a cure rate of 0.5 ft./min./lamp. Similarly, a belt speed of 10 ft./min. will provide 6 seconds of exposure or a rate of 5.0 ft./min./lamp, while a speed of 20.0 ft./min. will give 3 seconds exposure or a rate of 10 ft./min./lamp.

The extent of curing was determined by a standard pencil hardness test with all samples being coated on aluminum plate to a thickness of 2 mils and polymerized to achieve standard pencil hardness of from 4H to 6H where this was attainable.

## EXAMPLES 1-5

These Examples show the comparative cure rate in air (ft./min./lamp) for a benzoin ether photoinitiator (VICURE-10 brand from Stauffer Chemical Company which contains benzoin i-butyl ether as an active ingredient) at 4 wt. percent and the same photoinitiator promoted with a similar amount of various amine compounds.

| Amine Promoter | Cure Rate (ft./min./lamp) |
|---|---|
| None (Control) | 7.5 |
| Dimethylethanolamine | 25 |
| Tribenzylamine | 10.0 |
| N,N-dimethylaniline | 20.0 |
| Dimethyl phenylamine | 17.5 |

EXAMPLES 6 - 10

These Examples illustrate the promotion effect of varying weight percentages of N,N-diethylaniline as the amine promoter with a benzoin i-butyl ether photoinitiator (i.e., VICURE 10 brand). The photoinitiator was at 4 wt. percent in the standard acrylate test vehicles in all cases.

| Loading of Amine | Cure Rate (ft./min./lamp) |
|---|---|
| None | 7.5 |
| 0.9% | 12.5 |
| 2.0% | 12.5 |
| 4.0% | 20.0 |
| 6.0% | 25.0 |

The foregoing Examples should not be construed in a limiting sense since they merely illustrate certain embodiments of the present invention. The scope of protection sought is set forth in the claims which follow.

What is Claimed:

1. Photopolymerization of monomeric and polymeric compositions of photopolymerizable substances wherein a photoinitiator is admixed with a photopolymerizable composition and the mixture exposed to actinic radiation,
c h a r a c t e r i z e d in that
the photopolymerization is effectively initiated by a benzoin ether photoinitiator in the presence of an amine promoter for said photoinitiator.

2. The method of Claim 1 wherein the benzoin ether has the formula

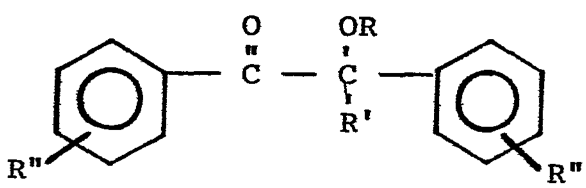

where R is alkyl and R' is selected from hydrogen, alkyl, halogen, and alkoxy and wherein one or more R'' groups can be optionally present on each phenyl ring and are selected from alkyl, alkoxy, halogen, and alkylamino.

3. The method of Claim 2,
c h a r a c t e r i z e d in that
R is an alkyl having up to 6 carbon atoms, and R' and R" independently from each other have up to 6 carbon atoms, when comprising an alkyl or alkyl moiety, or both are hydrogen.

4. The method of one of the claims 1 through 3, c h a r a c t e r i z e d in that a tertiary alkanol amine is used as said amine promoter.

5. A composition photopolymerizable by actinic radiation comprising unsaturated polymerizable constituents containing dispersed therein an effective amount of a combination of a benzoin ether photoinitiator and an amine promoter for said photoinitiator.

6. The composition of Claim 5 wherein the benzoin ether has the formula

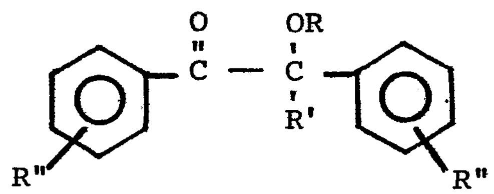

where R is alkyl and R' is selected from hydrogen, alkyl, halogen and alkoxy and wherein one or more R" groups can be optionally present on each phenyl ring and are selected from alkyl, alkoxy, halogen, and alkylamino.

7. The composition of Claim 6, c h a r a c t e r i z e d in that R is an alkyl having up to 6 carbon atoms, and R' and R" independently from each other have up to 6 carbon atoms, when comprising an alkyl or alkyl moiety, or both are hydrogen.

8. The composition of one of the Claims 5 through 7, c h a r a c t e r i z e d in that said amine promoter is a tertiary amine.

9. The composition of Claim 8, characterized in that said amine promoter is a tertiary alkanol amine.

10. The use of tertiary amines containing an alkanol group, especially the use of ~~di~~meethylethanol amine as an enhancing promoter in the photoinitiation of benzoin ether photoinitiators.

European Patent Office

# EUROPEAN SEARCH REPORT

0128320

Application number

EP 84 10 4840

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| X | GB-A-1 529 863 (I.C.I.)<br>* Claims 1,17,18 *<br>--- | 1-10 | C 08 F 2/50<br>G 03 C 1/68 |
| X | FR-A-2 216 304 (SUN CHEMICAL CORP.)<br>* Claims 1,4 *<br>----- | 1-10 | |
| | | | TECHNICAL FIELDS SEARCHED (Int. Cl. 3) |
| | | | C 08 F<br>G 03 C |

The present search report has been drawn up for all claims

| Place of search | Date of completion of the search | Examiner |
|---|---|---|
| THE HAGUE | 08-08-1984 | CAUWENBERG C.L.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document